# EUROPEAN PATENT APPLICATION

(11) **EP 1 626 447 A1**
(43) Date of publication of application: **15.02.2006**
(21) Application number: 04729814.6
(22) Date of filing: 28.04.2004
(51) Int. Cl.: H01L 33/00, H01S 5/00

(54) **A LIGHT EMITTING DIODE EMITTING UNIFORMLY LIGHT ALL AROUND**

(30) Priority: 30.04.2003 CN 03225716
(71) Applicant: Xu, Peixin, Guangdong 519001 (CN)
(72) Inventor: Xu, Peixin, Guangdong 519001 (CN)
(74) Representative: Urner, Peter
(86) International application number: PCT/CN2004/000416
(87) International publication number: WO 2004/102683

(57) **Abstract**

A light-emitting diode which emits light uniformly emitted all around is provided. The present invention comprise a light emitting diode (LED) chip, a transparent envelop body and a connection pin, which is **characterized in that** top of said envelop body being inward concave. Since the present invention uses a structure which the top of the envelop body is disposed as a inward concave shape, it skillfully makes use of the optical spreading characteristic of the inward concave body. Which makes light beam which is emitted by the light emitting diode chip emit uniformly all around the envelop body via refraction of a plurality of the sides of the inward concave body. At the same time, in order to further enhance its decorative, said envelop body is set to different colour coloured body. Therefore, it may emit light all around, and which has a simple structure, easy to manufacture, low manufacturing cost, good decorative effect. Thus, it can be applied to in the field of all sorts of new type lamps.

## Description

### BACKGROUND OF THE INVENTION

### Field of Invention

The present invention relates in general to a light-emitting diode (LED), and more particular, to a light-emitting diode operative to emit uniform light to the ambient thereof.

### Related Art

The further technical advancement and the inherent features such as low driving voltage, low heat, and uneasily broken structure have acquired broader application in various types of lighting devices, particularly the decorative lamps. The commonly used light-emitting diode includes a light-emitting diode chip encapsulated within a transparent or translucent casing. The casing is configured to provide converging effect. Therefore, the light is typically concentrated within a narrow viewing angle. The light is very dim for the observer positioning beyond the narrow viewing angle. To resolve the narrow viewing angle problem, different configurations of the casing such as wedge or polygonal have been proposed. The configuration with wedged surface allow the light generated by the light-emitting diode to reflect towards specific angle. However, the majority of light is still concentrated upfront. The lateral light is still very limited. In Chinese Patent No. ZL98248949, glass beads are added within the casing for a light-emitting diode envelop body to cause the light reflected laterally. However, as the density of the glass beads is different from that of epoxy used for fabricating the casing, the glass beads are often non-uniformly distributed within the casing to result in non-uniform light. In addition, this type of light-emitting diode device is laborious and more costly.

### SUMMARY OF THE INVENTION

A light-emitting diode device is provided to generate uniform light with large viewing angle. The light-emitting as provided has a simple structure, such that the process complexity and cost are greatly reduced.

The light-emitting diode device of the present invention is fulfilled as follows.

The light-emitting diode device includes a light-emitting diode chip, a transparent envelop body, a connection pin, which is characterized in that the top of the envelop body forms an inward concave.

The shape of the envelop body or the inward concave can be changed as desired. For example, the envelop body can be formed as a cylindrical body and the inward concave can be formed as a conic or a semi-spherical concave with an angle around 100° to 160°.

Color envelop body can be used to provide desired visual effect.

By configuring the indented top surface of the envelop body into the inward concave structure, the light generated by the light-emitting diode chip is properly deflected, reflected and diffused into a uniform light emitted with a wide angle. The cylindrical body and the indented top surface can be easily fabricated with much lower cost. More important, the light-emitting diode device adapting such envelop body is operative to generate light propagating both forwardly and laterally, such that the observer at the side of the light-emitting diode device can easily observes the light generated thereby, while the observes right in front of the light-emitting diode device will not be dashed by the concentrated light.

### BRIEF DESCRIPTION OF THE DRAWINGS

The present invention will become more fully understood from the detailed description given hereinbelow illustration only, and thus are not limitative of the present invention, and wherein:
FIG. 1 shows a perspective view of a light-emitting diode device according to the present invention;
FIG. 2 shows a top view of the light-emitting diode device as shown in Figure 1;
FIG. 3 shows a cross sectional view of the light-emitting diode device along the A-A line in Figure 2;
FIG. 4 shows the propagation of light generated by the light-emitting diode device; and
FIG. 5 shows a light-emitting diode device includes various color light-emitting diode chips to emit blue or white color of light.

### DETAILED DESCRIPTION OF THE INVENTION

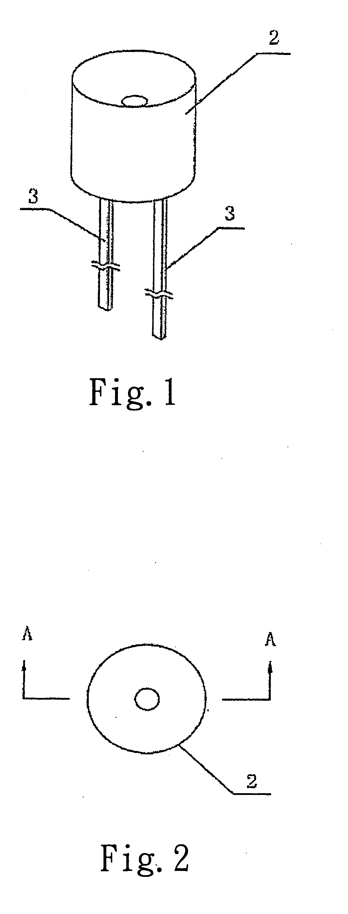

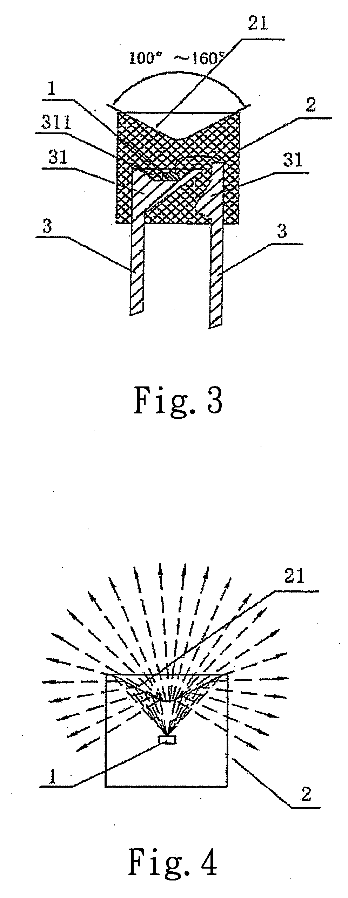

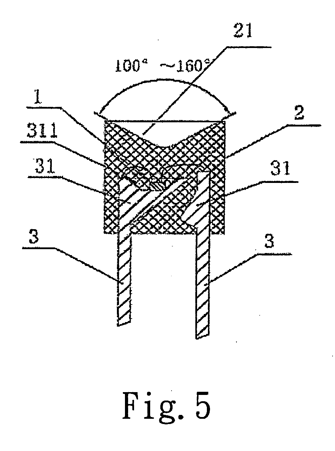

As shown in Figures 1 and 3, the light-emitting diode device includes a light-emitting diode chip 1, connection pins 3 and a transparent envelop body 2 for encapsulating the light-emitting diode chip 1 therein. The connection pins 3 extend from the light-emitting diode chip 1 through the envelop body 2 to provide electric connection to an external device such as a power source. The envelop body 2 can be fabricated from epoxy, for example. As shown, the internal ends of connection pins 3 are terminated with electrode frames 31 to prevent the connection pins 3 separately from engaging with the envelop body 2. The electrode frames 31 form a recessed space 311 for accommodating the light-emitting diode chip 1 therein to provide more forward focused light beam. The frames 31 include conductive wires for connecting the light-emitting diode chip 1. As shown in Figure 4, in order to satisfy user's need to emit light uniformly all around and to enhance decorative effects, the envelop body 2 has the top surface being indented. It skillfully makes use of the optical spreading characteristic of the inward concave so that light beam straightly emitted by the light emitting diode chip 1 toward the envelop body 2 will uniformly emit all around the envelop body 2 via refraction of a plurality of the sides of the inward concave. The envelop body 2 can be different kind of shape such as a cylindrical body or a semi-spherical body. The shape of the indented top surface can be changed as desired, for example, an inward concave 21. The inward concave 21 can be formed as a conic concave 21 or a polygonal concave. Alternatively, the top surface can be indented into a semi-spherical recess. As shown in Figure 3, to ensure the better performance, a curvature of the inward concave 21 can not be too small or too large; otherwise, light beam straightly emitted from the light emitting diode chip 1 will direct forwardly without sufficient light deflecting, reflecting and diffusing all around so that the lighting effect of the present invention is reduced. Therefore, an angle of the curvature is between 100° to 160°, preferably, between 130° to 140° to optimize the uniformity. Further, the envelop body 2 can be made with various colors to provide desired visual effect. Figure 3 shows the structure for the light-emitting diode device which provides any color of light except for blue or white color. Figure 5 shows a modification of the light-emitting diode device in which more than one light emitting diode chips are installed to generate blue or white color of light. Accordingly, it can emit light all around, and which has a simple structure, easy to manufacture, low manufacturing cost, good decorative effect. Thus, it can be applied to in the field of all sorts of new type lamps.

## Claims

1. A light-emitting diode device, comprising a light-emitting diode chip, a connection pin and a transparent envelop body, **characterized in that** a top surface of the envelop body being indented.

2. The device of Claim 1, wherein the envelop body is a cylindrical body and the indented top surface forms an inward concave.

3. The device of Claim 2, wherein the inward concave is a conic concave.

4. The device of Claim 2, wherein the inward concave is a polygonal concave.

5. The device of Claim 1 or 2, wherein a curvature of the inward concave is about 100° to 160°.

6. The device of Claim 5, wherein the curvature is 130° to 140°.

7. The device of Claim 2, wherein the envelop body is a cylindrical body and the indented top surface forms a semi-spherical recess.

8. The device of claim 1, wherein the envelop body has a color substantially the same as that of the light generated by the light-emitting diode chip.

9. The device of Claim 1, wherein the connecting pin has an internal end terminated with a frame for holding the light-emitting diode chip and the frame forms a recessed space for accommodating the light-emitting diode chip therein.

## Amended claims

### Amended claims under Art. 19.1 PCT

1. A light-emitting diode device, comprising a light-emitting diode die, a connection pin and a transparent envelop body, **characterized in that** the envelop body is a cylindrical body and a top surface of the envelop body being indented to form a conic concave or a polygonal concave with a tip angle between 100° to 140°.

2. The device of Claim 1, wherein the tip angle is 130° to 140°.

3. The device of claim 1, wherein the envelop body has a color substantially the same as that of the light generated by the light-emitting diode die.

4. The device of Claim 1, wherein the connection pin has an internal end terminated with a frame for holding the light-emitting diode die and the frame forms a recessed space for accommodating the light-emitting diode die therein.

5. A light-emitting diode device, comprising a light-emitting diode die, a connection pin and a transparent envelop body, **characterized in that** the envelop body is a cylindrical body and a top surface of the envelop body being indented to form a semi-spherical recess.

6. The device of claim 5, wherein the envelop body has a color substantially the same as that of the light generated by the light-emitting diode die.

7. The device of Claim 5, wherein the connection pin has an internal end terminated with a frame for holding the light-emitting diode die and the frame forms a recessed space for accommodating the light-emitting diode die therein.

Statement under Art. 19.1 PCT
**Translation of response(amendment) to search report**
 Response

Claims amended as follows.
 Amended claims 1-7 substitute original claims 1-9.
 Amended claim 1 is based on original claims 1-5.
 Amended claim 2 is based on original claim 6.
 Amended claim 3 is based on original claim 8.
 Amended claim 4 is based on original claim 9.
 Amended claim 5 is based on original claim 7.
 Amended claim 6 is based on original claim 8.
 Amended claim 7 is based on original claim 9.
 Meanwhile, the abstract is amended and all "light-emitting diode chip" in the specification
 are amended to "light-emitting diode die".

Remarks
 The amended claim 1 includes the envelop body as a cylindrical body and a top surface of the envelop body being indented to form a conic concave or a polygonal concave with a tip angle between 100° to 140°, which does not disclosed in cited reference 1 (USP 6,361,190). Therefore, the amended claim 1 is patentable over reference 1.

Although reference 1 discloses an angle between 0 to 150° for light beam emitted from the light-emitting diode die to emit all around the envelop body; however, reference 1 does not disclose how to uniformly emit the light. The present invention is to provide uniform light from emitted light-emitting diode die through the envelop body with large viewing angle. Obviously, the object of the present invention is distinct from reference 1. In technical, the inventor obtains from experiments that when merely the envelop body being indented to form the tip angle between 100° to 140°, the light emitted from the light-emitting diode die toward the inner surface of the indented top can be uniformly emitted all around.
 Furthermore, in order to optimize the best light deflecting and reflecting effect, the angle is around 130° to 140°. If the angle is less than 100° or larger than 140°; the lighting effect will be reduced. As such, the amended claim 1 as a whole is not anticipated by reference 1 because of the unforeseeable result. The amended claim 1 is non-obvious with inventive step.

Accordingly, the amended claims 2-4 depended on amended claim 1 are patentable. Furthermore, the amended claim 5 includes the top surface of the envelop body being indented to form a semi-spherical recess so as to provide uniform light from emitted light-emitting diode die through the envelop body with large viewing angle, which does not disclosed in cited reference 1. Therefore, with the similar reason as mentioned above, the amended claim 5 is patentable.

Accordingly, the amended claims 6 and 7 depended on amended claim 5 are patentable.

Applicant submits that the amended claims 1-7 are patentable in compliant with PCT rules with respect to novelty and inventive step.
